# FASCICULE DE BREVET EUROPEEN

(11) **EP 1 776 447 B1**
(45) Date de publication et mention de la délivrance du brevet: **28.11.2007**
(21) Numéro de dépôt: 05791133.1
(22) Date de dépôt: 20.07.2005
(51) Int. Cl.: C11D 7/50, C23G 5/028

(54) **COMPOSITION A BASE DE 1,1,1,3,3 - PENTAFLUOROBUTANE, UTILISABLE DANS DES APPLICATIONS DE DEPOT, NETTOYAGE, DEGRAISSAGE ET SECHAGE**
ZUSAMMENSETZUNG AUS 1,1,1,3,3-PENTAFLUOROBUTAN FÜR ENTFETTUNGS- UND TROCKNUNGSANWENDUNGEN ZUR ABLAGERUNGSENTFERNUNG
COMPOSITION MADE FROM 1,1,1,3,3 - PENTAFLUOROBUTANE OF USE IN DEPOSITION CLEANING DEGREASING AND DRYING APPLICATIONS

(30) Priorité: 18.08.2004 FR 0408957
(43) Date de publication de la demande: 25.04.2007
(73) Titulaire: ARKEMA FRANCE, 92700 Colombes (FR)
(72) Inventeur: CARON, Laurent, F-69110 Sainte Foy les Lyon (FR); LALLIER, Jean-Pierre, F-69720 Saint Bonnet de Mûre (FR); GUILPAIN, Gérard, 69126 Brindas (FR)
(74) Mandataire: Dang, Doris
(86) Numéro de dépôt international: PCT/FR2005/001849
(87) Numéro de publication internationale: WO 2006/027439

(56) Documents cités:
- WO-A-00/56833
- FR-A- 2 694 942
- US-A- 5 350 534
- US-A1- 2004 013 610

## Description

La présente invention concerne une composition à base de 1,1,1,3,3-pentafluorobutane ( HFC- 365 mfc), utilisable dans des applications de dépôt, nettoyage, dégraissage et de séchage. Elle a également pour objet un fluide de nettoyage des systèmes internes de transfert de chaleur. La présente invention a en outre pour objet un procédé de dissolution d'huile et de nettoyage.

Le pouvoir d'un solvant est en général caractérisé par l'Indice Kauri-Butanol qui est le volume en ml à 25°C d'un solvant nécessaire pour produire un degré défini de turbidité lorsqu'on ajoute 20 g d'une solution standard de résine Kauri dans du n-butanol. Cet indice est égal à 57 pour le 1,1-dichloro-1-fluoroéthane (connu sous la dénomination HCFC- 141b).

Outre son bon pouvoir solvant, le HCFC - 141b est également caractérisé par une faible tension superficielle (égale à 19,3 mN/m) ce qui lui procure une très bonne aptitude au mouillage des surfaces. Le point d'ébullition du HCFC - 141b étant égal à 32°C, ceci lui permet de s'évaporer rapidement et de faciliter ainsi les dépôts de produits dissouts sur des substrats. Enfin, le HCFC - 141b n'a pas de point d'éclair en coupe fermée et est donc un solvant non inflammable.

Le HCFC- 141b possède donc des propriétés qui lui confère une bonne aptitude à solubiliser de nombreux composés organiques, notamment les huiles de silicone.

Toutefois, en raison de son action sur la couche d'ozone qui n'est pas nulle (Potentiel de dégradation de l'ozone ODP = 0,11), le HCFC - 141b est soumis à une réglementation importante qui vise de plus en plus à le supprimer. Ainsi, la réglementation européenne sur les substances nuisibles à la couche d'ozone (n°2037/2000) interdit l'utilisation des HCFC (hydrochlorofluorocarbures) tels que le HCFC - 141b dans les applications solvants depuis le 1er janvier 2002, sauf pour les domaines de l'aéronautique et de l'aérospatiale où l'interdiction prend effet à partir de 2009 sur le territoire européen.

Le document EP 974642 propose une composition azéotropique de 1,1,1,3,3 - pentafluorobutane ( connu sous la dénomination HFC- 365mfc ) et de 1,1,1,2,3,4,4,5,5,5-décafluoropentane ( connu sous la dénomination HFC - 4310mee ) comme substituts au HCFC-141b en raison de leur absence d'effet sur la couche d'ozone. Cependant l'indice Kauri-Butanol d'une telle composition est beaucoup plus faible que le HCFC- 141b. L'indice Kauri-Butanol pour le HFC- 365mfc est de 12 et il est égal à 9 pour le HFC-4310mee.

Le document EP 1354985 propose, en remplacement du HCFC- 141b, un fluide de nettoyage pour installation frigorifique comprenant une huile de nettoyage en mélange avec un gaz liquéfié de transport avec lequel elle forme par détente une mousse de nettoyage.

On connaît par ailleurs une composition comprenant de 30 à 70 % en poids de 1,1,1,3,3 - pentafluorobutane et de 70 à 30 % en poids de chlorure de méthylène (FR 2694942).

Il est également connu du document WO 00/56833, une composition comprenant du HFC- 4310mee, du HFC- 365mfc et du trans-1,2 dichloroéthylène. Les exemples 4 et 5 de ce document décrivent des tests de solubilité, à température ambiante, d'huile minérale et d'huile silicone DC-200.

Par ailleurs, dans le cadre de la protection de l'environnement, la tendance actuelle est vers la diminution des émissions de solvant par évaporation. C'est ainsi que dans de nombreuses applications dites émissives, c'est-à-dire pour lesquelles le solvant est susceptible de s'évaporer dans l'air, des solvants efficaces à température plus basse que l'ambiante sont recherchés.

La présente invention fournit donc:
1) une composition comprenant du 1,1,1,3,3 - pentafluorobutane, du chlorure de méthylène et du trans-1,2 dichloroéthylène.
2) une composition comprenant de 25 à 69 % en poids de HFC- 365 mfc, de 25 à 69 % en poids de chlorure de méthylène et de 1 à 40 % en poids de trans-1,2 dichloroéthylène.
3) une composition comprenant de 40 à 57 % en poids de HFC- 365 mfc, de 30 à 43 % en poids de chlorure de méthylène et de 1 à 30 % en poids de trans-1,2 dichloroéthylène.

Les compositions selon la présente invention peuvent être préparées par mélange des différents constituants. Elles sont avantageusement préparées par ajout du trans-1,2 dichloroéthylène à une composition azéotropique ou quasi azéotropique de HFC- 365 mfc et de chlorure de méthylène.

Les compositions selon la présente invention peuvent être utilisées dans l'industrie pour le nettoyage, le dégraissage et le séchage de surfaces solides très diverses ( pièces métalliques, verres, plastiques, composites). Elles peuvent également être utilisées dans la fabrication des circuits imprimés pour éliminer les résidus des substances utilisées pour améliorer la qualité des soudures. Cette opération d'élimination est désignée dans le métier par le terme de « défluxage ».

Les compositions selon la présente invention peuvent avantageusement être utilisées pour le dépôt des huiles de silicone de grade médical sur des instruments , par exemple sur des aiguilles de seringues ou pour cathéters. En outre, elles peuvent être utilisées pour le dépôt des huiles de silicone sur des ustensiles de cuisine.

Ces compositions peuvent aussi être utilisées comme agent de dépôt des graisses ou polymères à base de silicone ou dans les formules de nettoyage de pièces revêtues d'huiles ou de graisses de silicone.

Les compositions selon la présente invention peuvent également être utilisées pour solubiliser des huiles de silicone entrant dans la formulation d'agents anti-adhésifs (souvent sous forme d'aérosols) pour moules dans les procédés de fabrication de pièces en plastiques (extrusion).

Les compositions peuvent en outre être utilisées comme agent d'expansion des mousses polyuréthanne, comme agent propulseur d'aérosols, comme fluide caloporteur, comme agent de nettoyage à sec des textiles ou de nettoyage d'installations frigorifiques.

La présente invention a également pour objet un procédé de dissolution d'huile à basse température. Ce procédé est caractérisé en ce que l'on utilise la composition décrite au point 1).

Le procédé, selon la présente invention, est de préférence mis en oeuvre à une température inférieure à 10 °C. Une température comprise entre 0 et 8° C est également préférée. Une température comprise entre 3 et 6 °C est avantageusement choisie.

La composition décrite au point 2) convient particulièrement au procédé de dissolution d'huile.

Le procédé, selon la présente invention, est avantageusement mis en oeuvre avec une composition décrite au point 3).

La présente invention a en outre pour objet un fluide de nettoyage des systèmes internes de transfert de chaleur, notamment les installations frigorifiques. Ce fluide de nettoyage est caractérisé par une composition décrite au point 1).

Un fluide de nettoyage de composition telle que décrite au point 2) est préférée.

Un fluide de nettoyage de composition telle que décrite au point 3) est particulièrement préférée.

Un autre objet de la présente invention est un procédé de nettoyage des systèmes internes de transfert de chaleur, notamment les installations frigorifiques. Ce procédé est caractérisé en ce que l'on utilise un fluide de composition décrite au point 1).

Le procédé de nettoyage est de préférence mis en oeuvre à l'aide d'un fluide de composition telle que décrite au point 2).

Un fluide de composition telle que décrite au point 3) est avantageusement choisi pour le procédé de nettoyage des systèmes internes de transfert de chaleur.

### PARTIE EXPERIMENTALE

Les compositions suivantes ont été préparées :
Composition A : Azéotrope 57 % en poids de HFC 365mfc et 43 % en poids de chlorure de méthylène
Composition B : 40 % en poids de HFC- 365mfc et 30% en poids de chlorure de méthylène et 30 % en poids de trans-1,2 dichloroéthylène
Composition C : 51 % en poids de HFC- 365mfc et 39 % en poids de chlorure de méthylène et 10 % en poids de trans-1,2 dichloroéthylène
Composition D : 85 % en poids de HFC- 365 et 15 % en poids de HFC-4310mee

### EXEMPLE 1

### Description des essais de solubilisation d'une huile de silicone

On utilise une huile de silicone Crompton L9000-1000 de la société Crompton Corporation (Greenwich, USA). Il s'agit d'un hydroxy-polydimethylsiloxane, liquide transparent ayant une densité de 0,97 à température ambiante (22°C), un point d'ébullition supérieur à 200°C et un point éclair de 132°C (méthode Pensky-Martens, en coupe fermée).

On prépare des mélanges à température ambiante, c'est-à-dire à 22°C. Ainsi, dans un flacon de 50 ml, on introduit 18 ml de la composition à tester et 1,94 g d'huile de silicone, c'est-à-dire qu'on réalise une solution à 10% volumique. On agite ensuite le mélange manuellement pendant 5 minutes.

Une partie du mélange ainsi préparé est maintenue au repos à température ambiante (22°C) pendant 24 heures. Une autre partie est maintenue au repos à basse température (6°C) pendant 7 jours.

Après la durée de stockage à différentes températures, on observe précisément l'aspect du mélange. On considère qu'il y a solubilité à température ambiante ou à 6°C lorsque le mélange est transparent, clair, homogène, monophasique et stable .

### Résultats

| Composition | Solubilité à 22°C | Solubilité à 6°C |
|---|---|---|
| HCFC- 141b | OUI | OUI |
| Composition A | OUI | NON |
| Composition B | OUI | OUI |

### EXEMPLE 2

### Description du test d'inflammabilité

Pour l'évaluation de l'inflammabilité des compositions, nous avons déterminé leur point éclair selon la méthode normalisée ASTM D3828, coupe fermée SETAFLASH. Le point éclair est la température minimale à laquelle un liquide dégage des vapeurs en quantité suffisante pour former à sa surface un mélange inflammable dans l'air sous l'action d'une source d'ignition, mais sans persistance de flammes au retrait de l'énergie d'activation.

Pour chacune des compositions, nous avons répété 5 fois la mesure.

### Résultats

| Composition | POINT ECLAIR |
|---|---|
| HCFC 141b | NON |
| Composition A | NON |
| Composition B | NON |

### EXEMPLE 3

### Description de la mesure de vitesse d'évaporation

On utilise une grille en acier inoxydable, de forme carrée de 4 cm de côté et possédant 30 fils par cm. Ce type de grille au maillage resserré permet d'obtenir une bonne rétention du solvant après trempage.

On trempe la grille dans un bécher de 100 ml contenant 80 ml de la composition à tester maintenue à température ambiante, sous ventilation contrôlée et stable.

On déclenche un chronomètre qui mesurera la vitesse d'évaporation au moment où on retire la grille totalement immergée de la composition à tester. La fin de l'évaporation est déterminée en observant le front de composition qui migre au cours du temps (à l'instant de fin d'évaporation, le front disparaît).Une quinzaine de mesures ont été réalisées et la valeur moyenne de ces mesures est reportée dans le tableau ci-après.

### Résultats

| Composition | Temps d'évaporation |
|---|---|
| HCFC 141b | 14 secondes |
| Composition A | 18 secondes |
| Composition B | 15 secondes |

### EXEMPLE 4

### Nettoyage d'installation frigorifique

On réalise un test de nettoyage à température ambiante sur le montage suivant, une installation frigorifique de volume interne environ 7L. 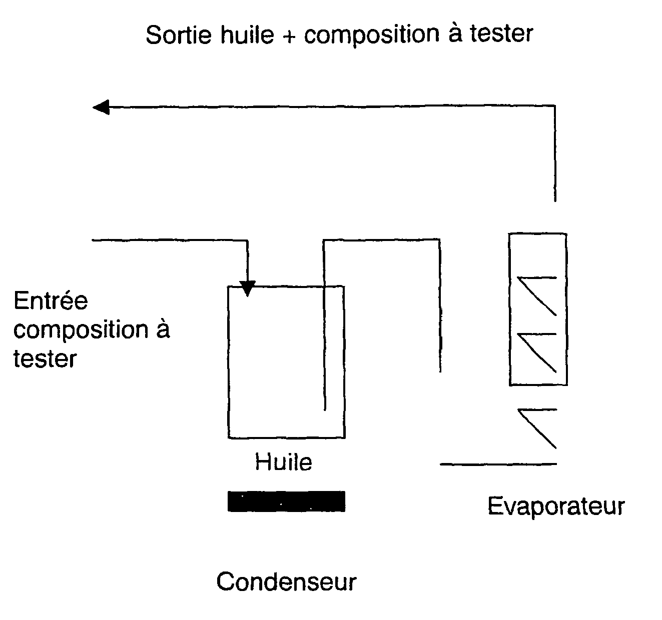
1) 50g d'huile de lubrification polluée (LUNARIA SR 68) est introduit dans le condenseur.
2) La composition C ou D est introduite dans le système par l'intermédiaire d'une pompe ou par pressurisation à l'azote jusqu'à remplissage total du système frigorifique.
3) Une majorité de la composition C ou D est alors évacuée par pressurisation à l'azote
4) Le résidu est évacué par tirage au vide

Le tableau suivant fournit la masse résiduelle contenue dans l'installation et le temps de tirage au vide nécessaire pour y arriver.

| Composition | Vide (h) | Masse restante (g) |
|---|---|---|
| HFC 141b | 2 | 0 |
| Composition C | 2h30 | 0 |
| Composition D | 4 | 38 |

## Revendications

1. Composition comprenant du 1,1,1,3,3 - pentafluorobutane, du chlorure de méthylène et du trans-1,2 dichloroéthylène.

2. Composition selon la revendication 1 **caractérisée en ce qu'**elle comprend de 25 à 69 % en poids de 1,1,1,3,3 - pentafluorobutane, de 25 à 69 % en poids de chlorure de méthylène et de 1 à 40 % en poids de trans-1,2 dichloroéthylène.

3. Composition selon la revendication 1 ou 2 **caractérisée en ce qu'**elle comprend de 40 à 57 % en poids de 1,1,1,3,3 - pentafluorobutane , de 30 à 43 % en poids de chlorure de méthylène et de 1 à 30 % en poids de trans-1,2 dichloroéthylène.

4. Procédé de dissolution d'huile à température inférieure à 10 ° C **caractérisé en ce que** l'on utilise une composition selon l'une quelconque des revendications 1 à 3.

5. Procédé selon la revendication 4 **caractérisé en ce que** la température de dissolution est comprise entre 0 et 8 ° C, de préférence entre 3 et 6 ° C.

6. Fluide de nettoyage des systèmes internes de transfert de chaleur **caractérisé par** une composition selon l'une quelconque des revendications 1 à 3.

7. Procédé de nettoyage des systèmes de transfert de chaleur **caractérisé en ce que** l'on utilise une composition selon l'une quelconque des revendications 1 à 3.

8. Utilisation de la composition selon l'une quelconque des revendications 1 à 3 comme agent d'expansion des mousses polyuréthanne, comme agent propulseur d'aérosols.

## Claims

1. Composition comprising 1,1,1,3,3-pentafluorobutane, methylene chloride and trans-1,2-dichloroethylene.

2. Composition according to Claim 1, **characterized in that** it comprises 25 to 69% by weight of 1,1,1,3,3-pentafluorobutane, 25 to 69% by weight of methylene chloride and 1 to 40% by weight of trans-1,2-dichloroethylene.

3. Composition according to Claim 1 or 2, **characterized in that** it comprises 40 to 57% by weight of 1,1,1,3,3-pentafluorobutane, 30 to 43% by weight of methylene chloride and 1 to 30% by weight of trans-1,2-dichloroethylene.

4. Method for dissolving oil at a temperature below 10°C, **characterized in that** a composition is used according to any one of Claims 1 to 3.

5. Method according to Claim 4, **characterized in that** the dissolution temperature lies between 0 and 8°C, preferably between 3 and 6°C.

6. Fluid for cleaning internal heat-transfer systems, **characterized by** a composition according to any one of Claims 1 to 3.

7. Method for cleaning heat-transfer systems, **characterized in that** it uses a composition according to any one of Claims 1 to 3.

8. Use of a composition according to any one of Claims 1 to 3 as an expansion agent for polyurethane foams and as an aerosol propellant agent.

## Patentansprüche

1. Zusammensetzung, enthaltend 1,1,1,3,3-Pentafluorbutan, Methylenchlorid und trans-1,2-Dichlorethylen.

2. Zusammensetzung nach Anspruch 1, **dadurch gekennzeichnet, daß** sie 25 bis 69 Gew.-% 1,1,1,3,3-Pentafluorbutan, 25 bis 69 Gew.-% Methylenchlorid und 1 bis 40 Gew.-% trans-1,2-Dichlorethylen enthält.

3. Zusammensetzung nach Anspruch 1 oder 2, **dadurch gekennzeichnet, daß** sie 40 bis 57 Gew.-% 1,1,1,3,3-Pentafluorbutan, 30 bis 43 Gew.-% Methylenchlorid und 1 bis 30 Gew.-% trans-1,2-Dichlorethylen enthält.

4. Verfahren zum Auflösen eines Öls bei einer Temperatur von weniger als 10°C, **dadurch gekennzeichnet, daß** man eine Zusammensetzung nach einem der Ansprüche 1 bis 3 verwendet.

5. Verfahren nach Anspruch 4, **dadurch gekennzeichnet, daß** die Auflösungstemperatur zwischen 0 und 8°C und vorzugsweise zwischen 3 und 6°C liegt.

6. Reinigungsflüssigkeit für interne Wärmeübertragungssysteme, **gekennzeichnet durch** eine Zusammensetzung nach einem der Ansprüche 1 bis 3.

7. Verfahren zur Reinigung von Wärmeübertragungssystemen, **dadurch gekennzeichnet, daß** man eine Zusammensetzung nach einem der Ansprüche 1 bis 3 verwendet.

8. Verwendung einer Zusammensetzung nach einem der Ansprüche 1 bis 3 als Treibmittel für Polyurethanschaumstoffe und als Treibmittel für Aerosole.
